# EUROPEAN PATENT APPLICATION

(11) **EP 3 859 978 A1**
(43) Date of publication of application: **04.08.2021**
(21) Application number: 19872761.2
(22) Date of filing: 29.08.2019
(51) Int. Cl.: H03M 13/11

(54) **LOW DENSITY PARITY CHECK CODE-BASED DECODING METHOD AND APPARATUS**

(30) Priority: 16.10.2018 CN 201811204745
(71) Applicant: Huawei Technologies Co., Ltd., Shenzhen Guangdong 518129 (CN)
(72) Inventor: FAN, Jiaqi, Shenzhen, Guangdong 518129 (CN); LUO, Jun, Shenzhen, Guangdong 518129 (CN)
(74) Representative: Gill Jennings & Every LLP
(86) International application number: PCT/CN2019/103327
(87) International publication number: WO 2020/078113

(57) **Abstract**

This application discloses an LDPC-based decoding method and apparatus, and pertains to the field of communications technologies. In this application, n x L LLR values may be decoded based on a target element in a target basis matrix, and a non-target element in the target basis matrix is forbidden to participate in decoding the n x L LLR values. The non-target element is a zero matrix, and the LLR value does not change after the LLR value is processed based on the non-target element. Therefore, the non-target element in the target basis matrix is forbidden to participate in decoding. In this way, decoding of the LLR value is not affected. In addition, a decoding time overhead and an occupied resource are reduced and decoding performance is improved because the LLR value is no longer processed based on a non-target factor.

## Description

This application claims priority to Chinese Patent Application No. 201811204745.4, filed with the China National Intellectual Property Administration on October 16, 2018 and entitled "DECODING METHOD AND APPARATUS BASED ON LOW-DENSITY PARITY-CHECK CODE", which is incorporated herein by reference in its entirety.

### TECHNICAL FIELD

This application relates to the field of communications technologies, and in particular, to a decoding method and apparatus based on a low-density parity-check code.

### BACKGROUND

Low-density parity-check (low density parity check, LDPC) code is a block error-correcting code with a sparse check matrix. LDPC-based decoding has become a hot research topic in recent years because LDPC is applicable to encoding and decoding of various channels. The check matrix of the LDPC may be decomposed into a basis matrix and a lifting factor L, and each element in the basis matrix represents an L x L matrix. Decoding can be implemented by performing an operation on a plurality of log likelihood ratio (log likelihood ratio, LLR) values of a signal based on each element in the basis matrix and the lifting factor L.

In the foregoing solution, a decoding overhead is extremely high, and decoding performance is relatively low.

### SUMMARY

This application provides a decoding method and apparatus based on an LDPC code, to resolve a problem of a relatively high decoding time overhead and relatively low decoding performance in a related technology. The technical solutions are as follows.

According to a first aspect, a decoding method based on an LDPC code is provided. The method includes: obtaining n x L LLR values based on a quantity n of columns of a target basis matrix and a lifting factor L that correspond to a target check matrix, where the target check matrix is a check matrix of an LDPC code; decoding the n x L LLR values based on a target element in the target basis matrix without using a non-target element in the target basis matrix to decode the n x L LLR values, where the target element is an L x L non-zero matrix, and the non-target element is an L x L zero matrix.

The non-target element is a zero matrix, and the LLR value does not change after the LLR value is processed based on the zero matrix. Therefore, the non-target element in the target basis matrix is forbidden to participate in decoding. In this way, decoding of the LLR value is not affected. In addition, a decoding time overhead and an occupied resource are reduced and decoding performance is improved because the LLR value is no longer processed based on a non-target factor.

Optionally, the n x L LLR values are elements in n LLR sets, a quantity of elements in each of the n LLR sets is L, and the n LLR sets one-to-one correspond to the n columns in the target basis matrix.

An implementation process of decoding the n x L LLR values based on the target element in the target basis matrix, and forbidding the non-target element in the target basis matrix to participate in decoding the n x L LLR values may include: processing a stored first LLR set based on a first element, where the first element is a target element in the i^{th} column in the target basis matrix; and avoiding processing a stored second LLR set based on a second element, where the second element is a non-target element in the i^{th} column in the target basis matrix; where
i is a positive integer greater than 0 and less than n + 1; and when the first element is located in the first row of the target basis matrix, the first LLR set is an LLR set corresponding to the i^{th} column in the n LLR sets, or when the first element is not located in the first row of the target basis matrix, the first LLR set is an LLR set updated based on a target element that is before the first element and that is closest to the first element; and when the second element is located in the first row of the target basis matrix, the second LLR set is an LLR set corresponding to the i^{th} column in the n LLR sets, or when the second element is not located in the first row of the target basis matrix, the second LLR set is an LLR set updated based on a target element that is before the second element and that is closest to the second element.

It should be noted that avoiding processing the stored second LLR set based on the second element may be avoiding reading the stored second LLR set.

The second LLR set is stored in an RAM. In this case, the second LLR set is no longer read from the RAM. Therefore, an operation is not performed on the second element and the second LLR set, and a set obtained through the operation is not written back into the RAM. This reduces a time overhead and a resource overhead.

Optionally, in this embodiment of this application, the stored second LLR set may be read from the RAM, and avoiding processing the stored second LLR set based on the second element may be avoiding performing an operation on the second element and L LLR values in the second LLR set. In this way, because the operation is not performed on the second element and the second LLR set, and the set obtained through the operation is not written back into the RAM. This reduces the time overhead and the resource overhead.

Optionally, before the decoding the n x L LLR values based on a target element in the target basis matrix without using a non-target element in the target basis matrix to decode the n x L LLR values, the method may further include: obtaining an initial basis matrix of the target check matrix, where the initial basis matrix is a matrix of m x n dimensions; determining at least one target column based on elements included in the k^{th} row and the (k + 1)^{th} row of the initial basis matrix, where both an element in the k^{th} row and each of the at least one target column and an element in the (k + 1)^{th} row and each of the at least one target column are target elements, and k is a positive integer greater than 0 and less than m; and adjusting, based on the at least one target column, a sequence of the elements included in the k^{th} row and the (k + 1)^{th} row, to obtain the target basis matrix, where the element in the k^{th} row and the at least one target column is located before another element in the k^{th} row after the sequence is adjusted, and the element in the (k + 1)^{th} row and the at least one target column is located after another element in the (k + 1)^{th} row after the sequence is adjusted.

In this embodiment of this application, a sequence of elements in two adjacent rows may be adjusted. After adjustment, when decoding is performed, there is a time difference between decoding of a target element in the k^{th} row and the target column and decoding of a target element in the (k + 1)^{th} row and the target column. The time difference may be used to decode an element in the (k + 1)^{th} row without depending on a decoding result of the k^{th} row. Compared with a solution in the related technology in which the element in the (k + 1)^{th} row can be decoded only after all elements in the k^{th} row are decoded, the method provided in this embodiment of this application can simultaneously decode the two adjacent rows, thereby effectively reducing a decoding time overhead.

Optionally, before the decoding the n x L LLR values based on a target element in the target basis matrix without using a non-target element in the target basis matrix to decode the n x L LLR values, the method may further include: obtaining an initial basis matrix of the target check matrix, where the initial basis matrix is a matrix of m x n dimensions; and adjusting a sequence of a plurality of rows of the initial basis matrix to obtain the target basis matrix, where a time overhead corresponding to the target basis matrix is less than a time overhead corresponding to the initial basis matrix, the time overhead corresponding to the target basis matrix is a time overhead generated when the n x L LLR values are decoded based on the target element in the target basis matrix, and the time overhead corresponding to the initial basis matrix is a time overhead generated when the n x L LLR values are decoded based on a target element in the initial basis matrix.

In this embodiment of this application, a target basis matrix with a minimum time overhead may be determined by adjusting the sequence of the plurality of rows of the initial basis matrix. Then, a time overhead is reduced by forbidding the non-target element in the target basis matrix to participate in decoding. This further reduces a decoding overhead.

According to a second aspect, an LDPC-based decoding apparatus is provided. The LDPC-based decoding apparatus has a function of implementing a behavior of the LDPC-based decoding method in the first aspect. The LDPC-based decoding apparatus includes at least one module, and the at least one module is configured to implement the LDPC-based decoding method provided in the first aspect.

According to a third aspect, an LDPC-based decoding apparatus is provided. A structure of the LDPC-based decoding apparatus includes a processor and a memory. The memory is configured to: store a program that supports the LDPC-based decoding apparatus in performing the LDPC-based decoding method provided in the first aspect, and store data used to implement the LDPC-based decoding method provided in the first aspect. The processor is configured to execute the program stored in the memory. An operation apparatus of the storage device may further include a communications bus, and the communications bus is configured to establish a connection between the processor and the memory.

According to a fourth aspect, a computer-readable storage medium is provided. The computer-readable storage medium stores an instruction, and when the instruction is run on a computer, the computer is enabled to perform the LDPC-based decoding method according to the first aspect.

According to a fifth aspect, a computer program product including an instruction is provided. When the computer program product runs on a computer, the computer is enabled to perform the LDPC-based decoding method according to the first aspect.

Technical effects achieved in the second aspect, the third aspect, the fourth aspect, and the fifth aspect are similar to those achieved by using corresponding technical means in the first aspect. Details are not described herein.

The technical solutions provided in this application have at least the following beneficial effects.

In the embodiments of this application, the n x L LLR values may be decoded based on the target element in the target basis matrix, and the non-target element in the target basis matrix is forbidden to participate in decoding of the n x L LLR values. The non-target element is a zero matrix, and the LLR value does not change after the LLR value is processed based on the non-target element. Therefore, the non-target element in the target basis matrix is forbidden to participate in decoding. In this way, decoding of the LLR value is not affected. In addition, a decoding time overhead and an occupied resource are reduced and decoding performance is improved because the LLR value is no longer processed based on a non-target factor.

### BRIEF DESCRIPTION OF DRAWINGS

FIG. 1 is a schematic structural diagram of a computer device according to an embodiment of this application;
FIG. 2 is a flowchart of an LDPC-based decoding method according to an embodiment of this application;
FIG. 3 is a flowchart of an LDPC-based decoding method according to an embodiment of this application;
FIG. 4 is a flowchart of an LDPC-based decoding method according to an embodiment of this application; and
FIG. 5 is a schematic structural diagram of an LDPC-based decoding apparatus according to an embodiment of this application.

### DESCRIPTION OF EMBODIMENTS

To make the objectives, technical solutions, and advantages of this application clearer, the following further describes the implementations of this application in detail with reference to the accompanying drawings.

In a related technology, n x L LLR values may be decoded based on a quantity n of columns of a basis matrix and a lifting factor (lifting factor) L that correspond to a check matrix of an LDPC code. Because there are a relatively large quantity of LLR values, the LLR values may be usually stored in a random access memory (random access memory, RAM). When decoding is performed, the n x L LLR values may be read from the RAM, the n x L LLR values are evenly divided into n groups, and each group of LLR values corresponds to one column in the basis matrix. Then, a group of LLR values corresponding to a column in which a corresponding element is located is processed based on each of n elements in the first row of the basis matrix, to obtain n groups of LLR values updated for the first time, and the n groups of LLR values updated for the first time are written back into the RAM. After the n groups of LLR values updated for the first time are written back into the RAM, the n groups of LLR values are updated to the n groups of LLR values updated for the first time. In this case, decoding of the first row ends. When decoding of the second row starts, the n groups of LLR values updated for the first time are read from the RAM, a group of LLR values updated for the first time and corresponding to a column in which a corresponding element is located are processed based on each of n elements in the second row of the basis matrix, to obtain n groups of LLR values updated for the second time, and the n groups of LLR values updated for the second time are written back into the RAM. After the n groups of LLR values updated for the second time are written back into the RAM, the n groups of LLR values updated for the first time are updated to the n groups of LLR values updated for the second time. By analogy, until n groups of LLR values updated for the last time are obtained based on elements in the last row of the basis matrix, and written back into the RAM. In this case, a first iteration ends. Then, a second iteration starts, the n groups of LLR values updated for the last time in the first iteration are read from the RAM, and the n read groups of LLR values are processed according to the foregoing method. Then, for a process from decoding of the second row to decoding of the last row, refer to the foregoing first iteration. A plurality of iterations are performed according to the foregoing method, and when a quantity of iterations reaches a maximum value or decoding succeeds, n groups of LLR values updated for the last time in a last iteration are used as final decoding results.

It can be learned that in a related technology, in a decoding process of each row, a group of LLR values corresponding to a column in which a corresponding element is located needs to be processed based on each of n elements of a corresponding row. In this case, when a quantity n of columns of a basis matrix and a lifting factor L are relatively large, a decoding time overhead is extremely high, and decoding performance is relatively low.

For ease of understanding, the following describes terms in the foregoing related technology and the embodiments of this application.

The LDPC code may be represented by using three parameters (N, K, and P), where N is a code word code length, K is an information code length, P is a check code length, and P = N - K. When N = 6 and K = 3, it indicates that 3-bit information may be encoded into 6-bit information by using the LDPC code. In this case, P = 3, in other words, a length of a check code generated after encoding is 3 bits.

The check matrix of the LDPC code is a randomly generated matrix of P x N dimensions based on the foregoing parameters of the LDPC code. For example, when P = 32 and N = 80, the check matrix is a matrix of 32 x 80 dimensions.

The check matrix of the LDPC code may be decomposed into a basis matrix and a lifting factor L. In other words, the check matrix of the LDPC code may be represented by using the basis matrix and the lifting factor L. The basis matrix may be a matrix of m x n dimensions, where m = P/L, and n = N/L. The lifting factor L may be a size of a matrix represented by each element in the basis matrix, that is, each element included in the basis matrix may represent an L x L matrix. In addition, elements included in the basis matrix may be classified into two types based on a value of each element. An element whose value is not -1 represents an L x L non-zero matrix, and an element whose value is -1 represents an L x L zero matrix.

Table 1 shows a basis matrix of a check matrix of 32 x 80 dimensions, where dimensions of the basis matrix are 4 x 10, and a lifting factor L is 8. Because the lifting factor L = 8, a size of a matrix represented by each element in the basis matrix is 8 x 8.

**Table 1 Basis matrix of a check matrix of 32 x 80 dimensions**

| | | | | | | | | | |
|---|---|---|---|---|---|---|---|---|---|
| 3 | 1 | 4 | 2 | 4 | 2 | 6 | -1 | -1 | -1 |
| 2 | 0 | 4 | 4 | 1 | 5 | 4 | 3 | -1 | -1 |
| 1 | 3 | 5 | 2 | 5 | 4 | -1 | 2 | 7 | -1 |
| 7 | 6 | 3 | 5 | 7 | 2 | -1 | -1 | 2 | 5 |

It should be noted that for each element whose value is not -1 in the basis matrix, assuming that a value of the element whose value is not -1 is h, an L x L matrix represented by the element whose value is not -1 is a matrix obtained by cyclically shifting an L x L unit matrix rightwards for h times by column.

For example, if a value of an element whose value is not -1 in the second row and the second column in Table 1 is 0, it indicates that an 8 x 8 matrix corresponding to the element whose value is not -1 is a matrix obtained by cyclically shifting an 8 x 8 unit matrix rightwards for 0 times by column. To be specific, the 8 x 8 matrix corresponding to the element whose value is not -1 is an 8 x 8 unit matrix shown in Table 2.

**Table 2 Corresponding 8 x 8 matrix when the value of the element whose value is not -1 is 0**

| | | | | | | | |
|---|---|---|---|---|---|---|---|
| ***1*** | 0 | 0 | 0 | 0 | 0 | 0 | 0 |
| 0 | ***1*** | 0 | 0 | 0 | 0 | 0 | 0 |
| 0 | 0 | ***1*** | 0 | 0 | 0 | 0 | 0 |
| 0 | 0 | 0 | ***1*** | 0 | 0 | 0 | 0 |
| 0 | 0 | 0 | 0 | ***1*** | 0 | 0 | 0 |
| 0 | 0 | 0 | 0 | 0 | ***1*** | 0 | 0 |
| 0 | 0 | 0 | 0 | 0 | 0 | ***1*** | 0 |
| 0 | 0 | 0 | 0 | 0 | 0 | 0 | ***1*** |

For another example, if a value of an element whose value is not -1 in the first row and the second column in Table 1 is 1, it indicates that an 8 x 8 matrix corresponding to the element whose value is not -1 is a matrix obtained by cyclically shifting an 8 x 8 unit matrix rightwards for one time by column. To be specific, the 8 x 8 matrix corresponding to the element whose value is not -1 is an 8 x 8 matrix shown in Table 3.

**Table 3 Corresponding 8 x 8 matrix when the value of the element whose value is not -1 is 1**

| | | | | | | | |
|---|---|---|---|---|---|---|---|
| 0 | ***1*** | 0 | 0 | 0 | 0 | 0 | 0 |
| 0 | 0 | ***1*** | 0 | 0 | 0 | 0 | 0 |
| 0 | 0 | 0 | ***1*** | 0 | 0 | 0 | 0 |
| 0 | 0 | 0 | 0 | ***1*** | 0 | 0 | 0 |
| 0 | 0 | 0 | 0 | 0 | ***1*** | 0 | 0 |
| 0 | 0 | 0 | 0 | 0 | 0 | ***1*** | 0 |
| 0 | 0 | 0 | 0 | 0 | 0 | 0 | ***1*** |
| ***1*** | 0 | 0 | 0 | 0 | 0 | 0 | 0 |

For another example, if a value of an element whose value is not -1 in the first row and the first column in Table 1 is 3, it indicates that an 8 x 8 matrix corresponding to the element whose value is not -1 is a matrix obtained by cyclically shifting an 8 x 8 unit matrix rightwards for three times by column To be specific, the 8 x 8 matrix corresponding to the element whose value is not -1 is an 8 x 8 matrix shown in Table 4.

**Table 4 Corresponding 8 x 8 matrix when the value of the element whose value is not -1 is 3**

| | | | | | | | |
|---|---|---|---|---|---|---|---|
| 0 | 0 | 0 | ***1*** | 0 | 0 | 0 | 0 |
| 0 | 0 | 0 | 0 | ***1*** | 0 | 0 | 0 |
| 0 | 0 | 0 | 0 | 0 | ***1*** | 0 | 0 |
| 0 | 0 | 0 | 0 | 0 | 0 | ***1*** | 0 |
| 0 | 0 | 0 | 0 | 0 | 0 | 0 | ***1*** |
| ***1*** | 0 | 0 | 0 | 0 | 0 | 0 | 0 |
| 0 | ***1*** | 0 | 0 | 0 | 0 | 0 | 0 |
| 0 | 0 | ***1*** | 0 | 0 | 0 | 0 | 0 |

It should be noted that because a quantity of dimensions of the check matrix is usually relatively large, a storage amount is relatively large when the check matrix is stored. When the check matrix is represented in the foregoing manner, the check matrix may be decomposed into one basis matrix and one lifting factor. When the check matrix is stored, the basis matrix of m x n dimensions and the lifting factor L may be directly stored. Compared with directly storing the check matrix of P x N dimensions, directly storing the basis matrix of m x n dimensions and the lifting factor L greatly reduces the storage amount.

The following describes an application scenario in the embodiments of this application.

In the communications field, improving reliability and effectiveness of information transmission in a communications system as much as possible is a goal pursued by a communications technology research institute. In a digital communications system, reliability of information transmission can be effectively improved by using a channel coding technology. It should be noted that the channel coding technology is a technology that a transmit end device encodes to-be-sent original data by using a specific encoding method, and sends a signal obtained through encoding; and after receiving a number signal sent by the transmit end device, a receive end device may decode the encoded signal using a decoding method corresponding to the specific encoding method, to restore the encoded signal to the original data, so as to process the restored original data. When the specific encoding method used by the transmit end device is an LDPC-based encoding method, to be specific, when the encoded signal sent by the transmit end device is obtained by encoding the original data by using the LDPC-based encoding method, and when the receive end device receives the encoded signal, the encoded signal may be decoded by using a decoding method based on an LDPC code provided in the embodiments of this application, to obtain the original data.

The following describes a device in the decoding method based on an LDPC code provided in the embodiments of this application.

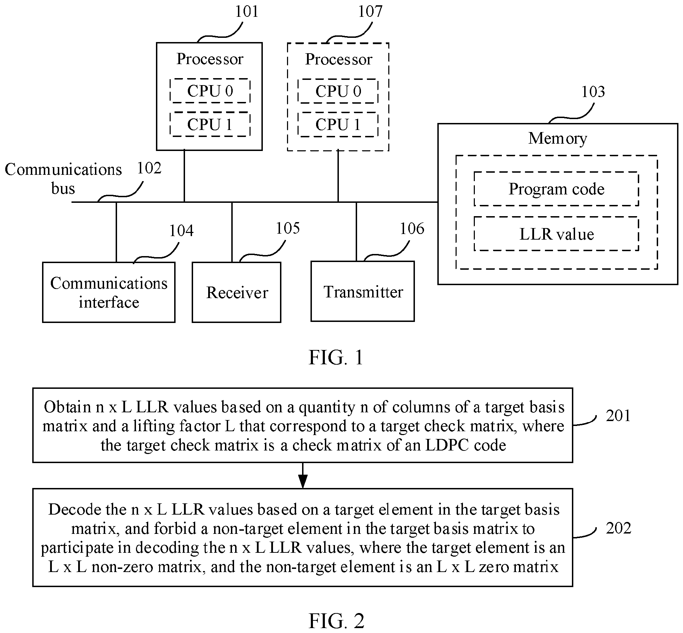

FIG. 1 is a schematic structural diagram of a computer device used for decoding according to an embodiment of this application. Referring to FIG. 1, the computer device includes at least one processor 101, a communications bus 102, a memory 103, at least one communications interface 104, a receiver 105, and a transmitter 106.

The processor 101 may be a general-purpose central processing unit (Central Processing Unit, CPU), a microprocessor, an application-specific integrated circuit (application-specific integrated circuit, ASIC), a field-programmable gate array (field-programmable gate array, FPGA), or one or more integrated circuits configured to control program execution in the solutions of this application. Alternatively, the processor 101 may be special-purpose hardware configured to control program execution in the solutions of this application.

The communications bus 102 may include a path used to transmit information between the foregoing components.

The memory 103 may be configured to store program code and a received LLR value. The memory 103 may be a read-only memory (read-only memory, ROM) or another type of static storage device capable of storing static information and an instruction, or a random access memory (random access memory, RAM) or another type of dynamic storage device capable of storing information and an instruction, or may be an electrically erasable programmable read-only memory (Electrically Erasable Programmable Read-Only Memory, EEPROM), a compact disc read-only memory (Compact Disc Read-Only Memory, CD-ROM) or another compact disc storage, an optical disc storage (including a compressed optical disc, a laser disc, an optical disc, a digital versatile disc, a Blu-ray disc, and the like), a magnetic disk storage medium or another magnetic storage device, or any other medium capable of carrying or storing expected program code in a form of an instruction or a data structure and capable of being accessed by a computer. However, the memory 103 is not limited thereto. The memory 103 may exist independently and is connected to the processor 101 through the communications bus 102. Alternatively, the memory 103 may be integrated with the processor 101.

The communications interface 104, which uses any apparatus such as a transceiver, is configured to communicate with another device or communications network, such as the Ethernet, a radio access network (RAN), or a wireless local area network (Wireless Local Area Networks, WLAN).

The receiver 105 may be configured to receive data, signaling, and/or the like sent by another device. For example, in this embodiment of this application, the receiver 105 may receive an LLR value sent by the another device. The transmitter 106 may be configured to send data, signaling, and/or the like to another device.

In specific implementation, in an embodiment, the processor 101 may include one or more CPUs, for example, a CPU 0 and a CPU 1 shown in FIG. 1.

In specific implementation, in an embodiment, the computer device may include a plurality of processors, for example, the processor 101 and a processor 107 shown in FIG. 1. Each of the processors may be a single-core (single-CPU) processor, or may be a multi-core (multi-CPU) processor. The processor herein may refer to one or more devices, circuits, and/or processing cores configured to process data (for example, a computer program instruction).

The computer device may be a general-purpose computer device or a special-purpose computer device. In specific implementation, the computer device may be a desktop, a portable computer, a network server, a personal digital assistant (Personal Digital Assistant, PDA), a mobile phone, a tablet computer, a wireless terminal device, a communications device, or an embedded device. A type of the computer device is not limited in this embodiment of this application.

The memory 103 is configured to store program code for executing the solutions of this application, and the processor 101 controls execution. The processor 101 may be configured to execute the program code stored in the memory 103. The program code may include one or more software modules. The processor 101 executes the one or more software modules in the program code in the memory 103, to decode the LLR value stored in the memory.

The following describes in detail the decoding method based on an LDPC code provided in the embodiments of this application.

FIG. 2 is a flowchart of a decoding method based on an LDPC code according to an embodiment of this application. The method may be applied to the computer device shown in FIG. 1. Referring to FIG. 2, the method includes the following steps.

Step 201: Obtain n x L LLR values based on a quantity n of columns of a target basis matrix and a lifting factor L that correspond to a target check matrix, where the target check matrix is a check matrix of an LDPC code.

In this embodiment of this application, the target check matrix may be a check matrix of any LDPC code, and the target basis matrix is a basis matrix corresponding to the target check matrix. Based on the foregoing description of the check matrix of the LDPC code, it can be learned that the target basis matrix corresponding to the target check matrix may be a matrix of m x n dimensions. In other words, the target basis matrix includes m rows and n columns. In this case, based on the quantity n of columns of the target basis matrix and the lifting factor L, the n x L LLR values may be obtained based on a sequence of receiving the LLR values.

It should be noted that, in a possible implementation, after the n x L LLR values are obtained, the n x L LLR values may be grouped into n LLR sets based on the sequence of receiving the LLR values, where each LLR set includes L LLR values. Then, the n LLR sets are stored in an RAM. The n LLR sets one-to-one correspond to the n columns in the target basis matrix.

Optionally, in another possible implementation, when the n x L LLR values are obtained based on the sequence of receiving the LLR values, L LLR values may be obtained each time based on the sequence of receiving the LLR values, the obtained L LLR values are used as one LLR set until n LLR sets are obtained, and the n LLR sets are stored in an RAM. The n LLR sets one-to-one correspond to the n columns in the target basis matrix.

Step 202: Decode the n x L LLR values based on a target element in the target basis matrix without using a non-target element in the target basis matrix to decode the n x L LLR values, where the target element is an L x L non-zero matrix, and the non-target element is an L x L zero matrix.

After the n x L LLR values are obtained, the obtained n x L LLR values may be decoded based on the target element in the target basis matrix, and the non-target element in the target basis matrix is forbidden to participate in decoding the n x L LLR values. The target element is an element whose value is not -1 in the target basis matrix, and the non-target element is an element whose value is -1 in the target basis matrix. Based on the foregoing description of the check matrix, it can be learned that an element whose value is not -1 in the basis matrix represents an L x L non-zero matrix, and an element whose value is -1 represents an L x L zero matrix. Therefore, the target element is actually a non-zero matrix, and the non-target element is a zero matrix. The non-target element represents an L x L zero matrix, and the LLR value does not change after an operation is performed on the LLR value and the L x L zero matrix. Therefore, the non-target element in the target basis matrix may be forbidden to participate in decoding, to reduce a decoding overhead.

Based on the description in step 201, it can be learned that the obtained n x L LLR values are used as elements in the n LLR sets, a quantity of elements in each of the n LLR sets is L, and the n LLR sets are one-to-one correspond to the n columns in the target basis matrix. Based on this, in this embodiment of this application, when the n x L LLR values are decoded based on the target element in the target basis matrix, and the non-target element in the target basis matrix is forbidden to participate in decoding the n x L LLR values, a stored first LLR set may be processed based on a first element, where the first element is a target element in the i^{th} column in the target basis matrix; and a stored second LLR set is avoided processing based on a second element, where the second element is a non-target element in the i^{th} column in the target basis matrix, i is a positive integer greater than 0 and less than n + 1. When the first element is located in the first row of the target basis matrix, the first LLR set is an LLR set corresponding to the i^{th} column in the n LLR sets. When the first element is not located in the first row of the target basis matrix, the first LLR set is an LLR set updated based on a target element that is before the first element and that is closest to the first element. When the second element is located in the first row of the target basis matrix, the second LLR set is an LLR set corresponding to the i^{th} column in the n LLR sets. When the second element is not located in the first row of the target basis matrix, the second LLR set is an LLR set updated based on a target element that is before the second element and that is closest to the second element.

The following describes the foregoing decoding process in detail by using an example.

When decoding is performed based on the target basis matrix, decoding is usually performed based on a row of the target basis matrix. To be specific, decoding may be performed row by row starting from the first row of the target basis matrix based on elements in each row of the target basis matrix.

For example, for a target basis matrix of m x n dimensions, decoding starts from the first row in the target basis matrix. If an element in the first row and the i^{th} column is a target element, an LLR set corresponding to the i^{th} column is read, based on the target element in the first row and the i^{th} column, from the n LLR sets stored in the RAM. Then, an operation may be performed on the LLR set corresponding to the i^{th} column based on the target element, to obtain an LLR set obtained after the operation. The LLR set obtained after the operation is written back into the RAM, to update the LLR set that corresponds to the i^{th} column and that is stored in the RAM. If the element in the first row and the i^{th} column is a non-target element, the LLR set corresponding to the i^{th} column may be forbidden to read from the n LLR sets stored in the RAM. Alternatively, the LLR set corresponding to the i^{th} column may be read from the n LLR sets stored in the RAM. However, after reading, an operation is forbidden to perform on the non-target element in the first row and the i^{th} column and the read LLR set corresponding to the i^{th} column. In this way, the non-target element is forbidden to participate in decoding.

For a j^{th} row of the target basis matrix, if an element in the j^{th} row and the i^{th} column is a target element, the LLR set that corresponds to the i^{th} column and that is stored in the RAM may be read from the RAM, and an operation is performed on the LLR set corresponding to the i^{th} column based on the target element in the j^{th} row and the i^{th} column, to obtain an LLR set obtained after the operation. The LLR set obtained after the operation is written back into the RAM, to update the LLR set that corresponds to the i^{th} column and that is stored in the RAM. If an element in the j^{th} row and the i^{th} column is a non-target element, the LLR set corresponding to the i^{th} column may be forbidden to read from the RAM Alternatively, the LLR set corresponding to the i^{th} column may be read from the n LLR sets stored in the RAM. However, after reading, an operation is forbidden to perform on the non-target element in the j^{th} row and the i^{th} column and the LLR set corresponding to the i^{th} column.

The LLR set corresponding to the i^{th} column is an LLR set updated based on a target element that is located before the target element in the j^{th} row and the i^{th} column and that is closest to the target element in the j^{th} row and the i^{th} column. For example, if an element in a (j - 1)^{th} row and the i^{th} column is a target element, the LLR set corresponding to the i^{th} column is an updated LLR set obtained by performing an operation on a target element in the (j - 1)^{th} row and the i^{th} column in a decoding process of the (j - 1)^{th} row. Certainly, if the element in the (j - 1)^{th} row and the i^{th} column is a non-target element, and an element in a (j - 2)^{th} row and the i^{th} column is a target element, it indicates that the LLR set corresponding to the i^{th} column is not updated in the decoding process of the (j - 1)^{th} row, but is updated in decoding of the (j - 2)^{th} row. In this case, the LLR set corresponding to the i^{th} column is an updated LLR set obtained by performing an operation the target element in the (j - 2)^{th} row and the i^{th} column in the decoding process of the (j - 2)^{th} row.

Decoding is performed row by row based on the target basis matrix in the foregoing manner. Each time when decoding is completed from the first row to the m^{th} row, a quantity of decoding times may be increased by 1. When j = m, that is, after decoding of the n^{th} row is completed, it may be detected whether an LLR set obtained through processing based on a target element in the m^{th} row meets a decoding requirement, or it may be detected whether the quantity of decoding times has reached an upper limit. If the LLR set obtained through processing based on the target element in the m^{th} row meets the decoding requirement, or the quantity of decoding times has reached the upper limit, the LLR set obtained through processing based on the target element in the n^{th} row and an LLR set that corresponds to a column in which a non-target element in the m^{th} row is located and that is stored in the RAM are determined as final decoding results. If the LLR set obtained through processing based on the target element in the m^{th} row does not meet the decoding requirement, and the quantity of decoding times does not reach the upper limit, decoding may be performed again starting from the first row of the target basis matrix in the foregoing manner. It should be noted that, when decoding is performed again starting from the first row, the LLR set that corresponds to the i^{th} column and that is read based on the element in the first row and the i^{th} column is an LLR set updated based on a target element in the m^{th} row and the i^{th} column in previous decoding, or an LLR set that corresponds to the i^{th} column, that is stored in the RAM, and that is not processed based on a non-target element in the m^{th} row and the i^{th} column in previous decoding.

In this embodiment of this application, when an element in the i^{th} column is a non-target element, the non-target element may be avoided to participate in decoding by forbidding to read the LLR set corresponding to the i^{th} column. The LLR set corresponding to the i^{th} column is forbidden to read. Therefore, there is no process of performing an operation on, writing back, and updating the LLR set corresponding to the i^{th} column. In this way, compared with the related technology, in this application, a read time, an operation time, and an update time can be reduced, that is, a decoding time overhead and a resource overhead are reduced. Alternatively, when an element in the i^{th} column is a non-target element, a non-target element may be avoided participating in decoding by forbidding an operation to perform on the LLR set corresponding to the i^{th} column and a non-target element in the i^{th} column. This omits an operation process, a write-back process, and an update process. Likewise, a decoding time overhead and an occupied resource can be reduced, and decoding performance is improved.

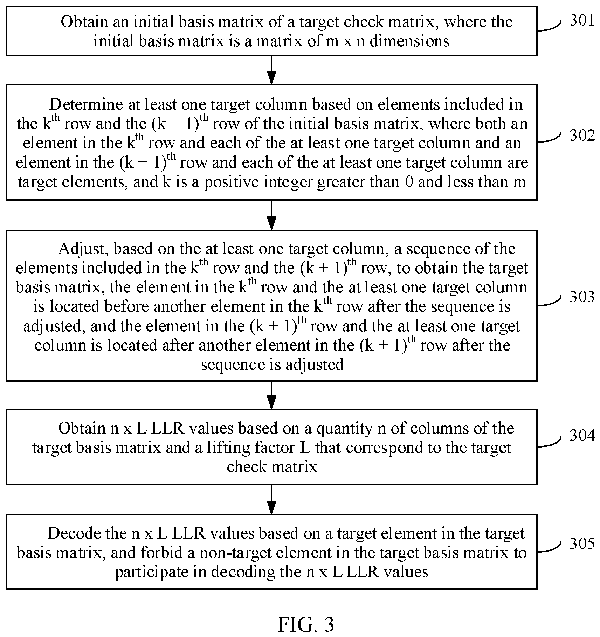

The foregoing embodiment mainly describes a method for reducing a decoding overhead by forbidding a non-target element in a target basis matrix to participate in decoding. The following describes another decoding method based on an LDPC code according to an embodiment of this application with reference to FIG. 3.

FIG. 3 is a flowchart of a decoding method based on an LDPC code according to an embodiment of this application. The method may be applied to the computer device shown in FIG. 1. Referring to FIG. 3, the method includes the following steps.

Step 301: Obtain an initial basis matrix of a target check matrix, where the initial basis matrix is a matrix of m x n dimensions.

In this embodiment of this application, the target check matrix may be a check matrix corresponding to any LDPC code, and the initial basis matrix of the target check matrix may be an unprocessed original basis matrix of m x n dimensions that corresponds to the target check matrix.

Step 302: Determine at least one target column based on elements included in the k^{th} row and the (k + 1)^{th} row of the initial basis matrix, where both an element in the k^{th} row and each of the at least one target column and an element in the (k + 1)^{th} row and each of the at least one target column are target elements, and k is a positive integer greater than 0 and less than m.

After the initial basis matrix is obtained, any two adjacent rows, namely, the k^{th} row and a (k - 1)^{th} row, may be selected from m rows included in the initial basis matrix, and the at least one target column is determined based on elements included in the k^{th} row and the (k - 1)^{th} row. Alternatively, starting from the first row of the initial basis matrix, two adjacent rows may be used as a row set, to obtain a plurality of row sets. The row sets do not include a same row. Then, for two adjacent rows included in each of the plurality of row sets, for example, the k^{th} row and the (k - 1)^{th} row, the at least one target column is determined based on elements included in the k^{th} row and the (k - 1)^{th} row.

An implementation process of determining the at least one target column based on the elements included in the k^{th} row and the (k - 1)^{th} row may be: determining the target element from elements included in the k^{th} row. If an element in the (k - 1)^{th} row and a column in which the target element in the k^{th} row is located is also a target element, the corresponding column may be determined as the target column. The target element is an L x L non-zero matrix, the non-target element is an L x L zero matrix, and L is a lifting factor of the target check matrix.

For example, two adjacent rows in an initial basis matrix shown in Table 5 are used to explain and describe the foregoing process. An element whose value is not -1 is a target element, and an element whose value is -1 is a non-target element. Based on this, columns in which the target elements in the first row are located are the first column, the second column, the fourth column, and the fifth column. An element in the second row and the first column is a non-target element. Therefore, the first column is not the target column. An element in the second row and the second column is a target element. Therefore, the second column is the target column. An element in the second row and the fourth column is a target element. Therefore, the fourth column is also the target column. An element in the second row and the fifth column is a non-target element. Therefore, the fifth column is not the target column. In conclusion, for the two adjacent rows shown in Table 5, the target columns are the second column and the fourth column, respectively.

**Table 5 Two adjacent rows in an initial basis matrix**

| | | | | | | | |
|---|---|---|---|---|---|---|---|
| 7 | 15 | -1 | 11 | 0 | -1 | -1 | -1 |
| -1 | 8 | 4 | 1 | -1 | 0 | -1 | -1 |

Step 303: Adjust, based on the at least one target column, a sequence of the elements included in the k^{th} row and the (k + 1)^{th} row, to obtain a target basis matrix. The element in the k^{th} row and the at least one target column is located before another element in the k^{th} row after the sequence is adjusted, and the element in the (k + 1)^{th} row and the at least one target column is located after another element in the (k + 1)^{th} row.

After the at least one target column is determined, the sequence of the elements included in the k^{th} row and the (k + 1)^{th} row may be adjusted based on the determined at least one target column. The element in the k^{th} row and the at least one target column may be adjusted to be before the another element, and the element in the (k + 1)^{th} row and the at least one target column may be adjusted to be after the another element.

For example, the two adjacent rows shown in Table 5 are still used as an example. The target columns are the second column and the fourth column. When a sequence is adjusted based on the target column, in the first row, the element 15 in the second column is adjusted to the first column, the element 11 in the fourth column is adjusted to the second column, and the remaining elements are arranged according to the previous sequence starting from the third column. In the second row, the element in the fourth column is adjusted to the last column, the element in the second column is adjusted to the penultimate column, and the remaining elements are arranged according to the previous sequence starting from the first column. An adjusted sequence of the elements in the two rows is shown in Table 6.

**Table 6 Two adjacent rows after a sequence of elements is adjusted**

| | | | | | | | |
|---|---|---|---|---|---|---|---|
| 15 | 11 | 7 | -1 | 0 | -1 | -1 | -1 |
| -1 | 4 | -1 | 0 | -1 | -1 | 8 | 1 |

It should be noted that, in this embodiment of this application, after the sequence of the elements in two adjacent rows is adjusted, although a sequence of the elements changes, a column corresponding to each element does not change. In other words, the foregoing adjustment to the sequence of the elements may be actually considered as adjustment of the sequence of the columns in each row.

After the sequence of the elements in the two adjacent rows is adjusted in the foregoing manner, an adjusted initial basis matrix may be determined as the target basis matrix. Then, n x L LLR values may be decoded based on the target basis matrix and the lifting factor L in the following steps.

Step 304: Obtain the n x L log likelihood ratio LLR values based on a quantity n of columns of the target basis matrix and the lifting factor L that correspond to the target check matrix.

For this step, refer to step 201 in the foregoing embodiment. Details are not described herein again in this embodiment of this application.

It should be noted that, although the sequence of the columns in each of the two adjacent rows is adjusted in steps 301 to 303, the column does not change. In other words, although locations of the elements are different, elements in a same column in the initial basis matrix correspond to the same column. For example, Table 5 and Table 6 are still used as examples for description. Although locations of the element 15 and the element 8 are different after adjustment, columns corresponding to the element 15 and the element 8 are still the same column.

Step 305: Decode the n x L LLR values based on a target element in the target basis matrix without using a non-target element in the target basis matrix to decode the n x L LLR values.

For this step, refer to step 202 in the foregoing embodiment. Details are not described herein again in this embodiment of this application.

In this embodiment of this application, for the k^{th} row and the (k + 1)^{th} row in the initial basis matrix, the at least one target column may be determined based on the elements included in the k^{th} row and the (k + 1)^{th} row, and both the element in the k^{th} row and each of the at least one target column and the element in the (k + 1)^{th} row and each of the at least one target column are both target elements. Then, an element in the k^{th} row and the target column is adjusted to be before a remaining element, and an element in the (k + 1)^{th} row and the target column is adjusted to be after a remaining element. In this way, in a subsequent decoding process, in the (k + 1)^{th} row, an element placed in the front does not need to depend on a decoding result of the k^{th} row. Therefore, decoding of the (k + 1)^{th} row may start when decoding of the k^{th} row is performed. In addition, decoding of the element in the (k + 1)^{th} row and the target column needs to depend on a decoding result obtained through decoding based on the element in the k^{th} row and the target column. Therefore, when decoding of the k^{th} row is performed, the element in the target column is placed at the forefront, and decoding may be first performed based on the element in the target column to obtain the decoding result, so that a decoding result can be obtained as early as possible during simultaneous decoding of the (k + 1)^{th} row, to complete decoding of an element adjusted to the (k + 1)^{th} row and located in the target column. In other words, through the foregoing adjustment, there is a time difference between decoding of a target element in the k^{th} row and the target column and decoding of a target element in the (k + 1)^{th} row and the target column. The time difference may be used to decode an element that is in the (k + 1)^{th} row and that does not need to depend on the decoding result of the k^{th} row. Compared with a solution in the related technology in which an element in the (k + 1)^{th} row can be decoded only after all the elements in the k^{th} row are decoded, the method provided in this embodiment of this application can implement simultaneous decoding of two adjacent rows, thereby effectively reducing a decoding time overhead.

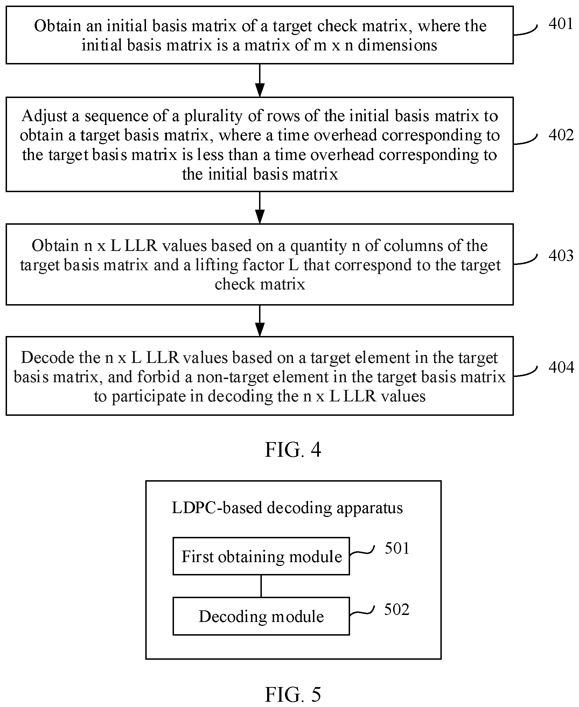

The foregoing embodiment mainly describes the method for reducing a decoding overhead by adjusting a sequence of elements in two adjacent rows and forbidding a non-target element in a target basis matrix to participate in decoding. The following describes another decoding method based on an LDPC code according to an embodiment of this application with reference to FIG. 4.

FIG. 4 is a flowchart of a decoding method based on an LDPC code according to an embodiment of this application. The method may be applied to the computer device shown in FIG. 1. Referring to FIG. 4, the method includes the following steps.

Step 401: Obtain an initial basis matrix of a target check matrix, where the initial basis matrix is a matrix of m x n dimensions.

For this step, refer to step 301 in the foregoing embodiment. Details are not described herein again in this embodiment of this application.

Step 402: Adjust a sequence of a plurality of rows of the initial basis matrix to obtain a target basis matrix, where a time overhead corresponding to the target basis matrix is less than a time overhead corresponding to the initial basis matrix.

The time overhead corresponding to the target basis matrix is a time overhead generated when n x L LLR values are decoded based on a target element in the target basis matrix, and the time overhead corresponding to the initial basis matrix is a time overhead generated when the n x L LLR values are decoded based on a target element in the initial basis matrix. The target element is an L x L non-zero matrix, a non-target element is an L x L zero matrix, and L is a lifting factor corresponding to the target check matrix.

It should be noted that, in this embodiment of this application, the sequence of the plurality of rows of the initial basis matrix may be randomly adjusted, and may be adjusted for a plurality of times. An initial base matrix obtained after each adjustment is used as one candidate basis matrix, to obtain a plurality of candidate basis matrices. The n x L LLR values are decoded based on each candidate basis matrix by using a simulation model, and time consumed for performing decoding based on each candidate basis matrix is determined. A candidate basis matrix that takes least time is selected from the plurality of candidate basis matrices, and the selected candidate basis matrix is determined as the target basis matrix. The simulation model may be a simulation model established based on the method provided in the embodiment shown in FIG. 2 or FIG. 3, or may be a simulation model established based on a decoding method in a related technology. This is not specifically limited in this embodiment of this application.

Step 403: Obtain the n x L log likelihood ratio LLR values based on a quantity n of columns of the target basis matrix and the lifting factor L that correspond to the target check matrix.

For this step, refer to step 201 in the foregoing embodiment. Details are not described herein again in this embodiment of this application.

Step 404: Decode the n x L LLR values based on the target element in the target basis matrix, and forbid the non-target element in the target basis matrix to participate in decoding the n x L LLR values.

For this step, refer to step 202 in the foregoing embodiment. Details are not described herein again in this embodiment of this application.

In this embodiment of this application, a target basis matrix with a minimum time overhead may be determined by adjusting the sequence of the plurality of rows of the initial basis matrix. Then, a time overhead is reduced by forbidding the non-target element in the target basis matrix to participate in decoding. This further reduces a decoding overhead.

Referring to FIG. 5, an embodiment of this application provides an LDPC-based decoding apparatus. The apparatus includes:
a first obtaining module 501, configured to perform step 201, 304, or 403 in the foregoing embodiment; and
a decoding module 502, configured to perform step 202, 305, or 404 in the foregoing embodiment.

Optionally, the n x L LLR values are elements in n LLR sets, a quantity of elements in each of the n LLR sets is L, and the n LLR sets one-to-one correspond to the n columns in the target basis matrix.

The decoding module 502 is specifically configured to:
process a stored first LLR set based on a first element, where the first element is a target element in the i^{th} column in the target basis matrix; and
avoid processing a stored second LLR set based on a second element, where the second element is a non-target element in the i^{th} column in the target basis matrix; where
i is a positive integer greater than 0 and less than n + 1; and when the first element is located in the first row of the target basis matrix, the first LLR set is an LLR set corresponding to the i^{th} column in the n LLR sets, or when the first element is not located in the first row of the target basis matrix, the first LLR set is an LLR set updated based on a target element that is before the first element and that is closest to the first element; and
when the second element is located in the first row of the target basis matrix, the second LLR set is an LLR set corresponding to the i^{th} column in the n LLR sets, or when the second element is not located in the first row of the target basis matrix, the second LLR set is an LLR set updated based on a target element that is before the second element and that is closest to the second element.

Optionally, the decoding module 502 is specifically configured to:
avoid reading the stored second LLR set.

Optionally, the apparatus is further configured to:
read the stored second LLR set.

The decoding module 502 is specifically configured to:
avoid performing an operation on the second element and L LLR values in the second LLR set.

Optionally, the apparatus further includes:
a second obtaining module, configured to obtain an initial basis matrix of the target check matrix, where the initial basis matrix is a matrix of m x n dimensions; and
a determining module, configured to determine at least one target column based on elements included in the k^{th} row and the (k + 1)^{th} row of the initial basis matrix, where both an element in the k^{th} row and each of the at least one target column and an element in the (k + 1)^{th} row and each of the at least one target column are target elements, and k is a positive integer greater than 0 and less than m; and
a first adjusting module, configured to adjust, based on the at least one target column, a sequence of the elements included in the k^{th} row and the (k + 1)^{th} row, to obtain the target basis matrix, where the element in the k^{th} row and the at least one target column is located before another element in the k^{th} row after the sequence is adjusted, and the element in the (k + 1)^{th} row and the at least one target column is located after another element in the (k + 1)^{th} row after the sequence is adjusted.

Optionally, the apparatus further includes:
a second obtaining module, configured to obtain an initial basis matrix of the target check matrix, where the initial basis matrix is a matrix of m x n dimensions; and
a second adjusting module, configured to adjust a sequence of a plurality of rows of the initial basis matrix to obtain the target basis matrix, where a time overhead corresponding to the target basis matrix is less than a time overhead corresponding to the initial basis matrix, the time overhead corresponding to the target basis matrix is a time overhead generated when the n x L LLR values are decoded based on the target element in the target basis matrix, and the time overhead corresponding to the initial basis matrix is a time overhead generated when the n x L LLR values are decoded based on a target element in the initial basis matrix.

In conclusion, in this embodiment of this application, the n x L LLR values may be decoded based on the target element in the target basis matrix, and the non-target element in the target basis matrix is forbidden to participate in decoding the n x L LLR values. The non-target element is a zero matrix, and the LLR value does not change after the LLR value is processed based on the non-target element. Therefore, the non-target element in the target basis matrix is forbidden to participate in decoding. In this way, decoding of the LLR value is not affected. In addition, a decoding time overhead and an occupied resource are reduced and decoding performance is improved because the LLR value is no longer processed based on a non-target factor.

It should be noted that, when the LDPC-based decoding apparatus provided in the foregoing embodiment performs decoding, only division into the foregoing functional modules is used as an example for description. In actual application, the foregoing functions may be allocated to and completed by different functional modules based on a requirement. In other words, an internal structure of the device is divided into different functional modules, to complete all or some of the foregoing functions. In addition, the LDPC-based decoding apparatus provided in the foregoing embodiment and the LDPC-based decoding method embodiment belong to a same concept. For a specific implementation process of the LDPC-based decoding apparatus, refer to the method embodiment. Details are not described herein.

All or some of the foregoing embodiments may be implemented by using software, hardware, firmware, or any combination thereof. When software is used to implement the embodiments, the embodiments may be implemented all or partially in a form of a computer program product. The computer program product includes one or more computer instructions. When the computer instructions are loaded and executed on a computer, the procedure or functions according to the embodiments of the present invention are all or partially generated. The computer may be a general-purpose computer, a special-purpose computer, a computer network, or another programmable apparatus. The computer instructions may be stored in a computer-readable storage medium or may be transmitted from a computer-readable storage medium to another computer-readable storage medium. For example, the computer instructions may be transmitted from a website, computer, server, or data center to another website, computer, server, or data center in a wired (for example, a coaxial cable, an optical fiber, or a digital subscriber line (Digital Subscriber Line, DSL)) or wireless (for example, infrared, radio, or microwave) manner. The computer-readable storage medium may be any usable medium accessible by a computer, or a data storage device, such as a server or a data center, integrating one or more usable media. The usable medium may be a magnetic medium (for example, a floppy disk, a hard disk, or a magnetic tape), an optical medium (for example, a digital versatile disc (Digital Versatile Disc, DVD), a semiconductor medium (for example, a solid-state drive (Solid State Disk, SSD)), or the like.

A person of ordinary skill in the art may understand that all or some of the steps of the embodiments may be implemented by using hardware or a program instructing related hardware. The program may be stored in a computer-readable storage medium, and the storage medium may include a read-only memory, a magnetic disk, or an optical disc.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A decoding method based on a low-density parity-check code, wherein the method comprises:
obtaining n x L log likelihood ratio LLR values based on a quantity n of columns of a target basis matrix and a lifting factor L that correspond to a target check matrix, wherein the target check matrix is a check matrix of a low-density parity-check LDPC code; and
decoding the n x L LLR values based on a target element in the target basis matrix without using a non-target element in the target basis matrix to decode the n x L LLR values, wherein the target element is an L x L non-zero matrix, and the non-target element is an L x L zero matrix.

2. The method according to claim 1, wherein the n x L LLR values are elements in n LLR sets, a quantity of elements in each of the n LLR sets is L, and the n LLR sets one-to-one correspond to the n columns in the target basis matrix; and
the decoding the n x L LLR values based on a target element in the target basis matrix without using a non-target element in the target basis matrix to decode the n x L LLR values comprises:
processing a stored first LLR set based on a first element, wherein the first element is a target element in the i^{th} column in the target basis matrix; and
avoiding processing a stored second LLR set based on a second element, wherein the second element is a non-target element in the i^{th} column in the target basis matrix; wherein
i is a positive integer greater than 0 and less than n + 1; and when the first element is located in the first row of the target basis matrix, the first LLR set is an LLR set corresponding to the i^{th} column in the n LLR sets, or when the first element is not located in the first row of the target basis matrix, the first LLR set is an LLR set updated based on a target element that is before the first element and that is closest to the first element; and
when the second element is located in the first row of the target basis matrix, the second LLR set is an LLR set corresponding to the i^{th} column in the n LLR sets, or when the second element is not located in the first row of the target basis matrix, the second LLR set is an LLR set updated based on a target element that is before the second element and that is closest to the second element.

3. The method according to claim 2, wherein the avoiding processing a stored second LLR set based on a second element comprises:
avoiding reading the stored second LLR set.

4. The method according to claim 2, wherein the method further comprises:
reading the stored second LLR set; and
the avoiding processing a stored second LLR set based on a second element comprises:
avoiding performing an operation on the second element and L LLR values in the second LLR set.

5. The method according to any one of claims 1 to 4, wherein the method further comprises:
obtaining an initial basis matrix of the target check matrix, wherein the initial basis matrix is a matrix of m x n dimensions;
determining at least one target column based on elements comprised in the k^{th} row and the (k + 1)^{th} row of the initial basis matrix, wherein both an element in the k^{th} row and each of the at least one target column and an element in the (k + 1)^{th} row and each of the at least one target column are target elements, and k is a positive integer greater than 0 and less than m; and
adjusting, based on the at least one target column, a sequence of the elements comprised in the k^{th} row and the (k + 1)^{th} row, to obtain the target basis matrix, wherein the element in the k^{th} row and the at least one target column is located before another element in the k^{th} row after the sequence is adjusted, and the element in the (k + 1)^{th} row and the at least one target column is located after another element in the (k + 1)^{th} row after the sequence is adjusted.

6. The method according to any one of claims 1 to 4, wherein the method further comprises:
obtaining an initial basis matrix of the target check matrix, wherein the initial basis matrix is a matrix of m x n dimensions; and
adjusting a sequence of a plurality of rows of the initial basis matrix to obtain the target basis matrix, wherein a time overhead corresponding to the target basis matrix is less than a time overhead corresponding to the initial basis matrix, the time overhead corresponding to the target basis matrix is a time overhead generated when the n x L LLR values are decoded based on the target element in the target basis matrix, and the time overhead corresponding to the initial basis matrix is a time overhead generated when the n x L LLR values are decoded based on a target element in the initial basis matrix.

7. A decoding apparatus based on a low-density parity-check code, wherein the apparatus comprises:
a first obtaining module, configured to obtain n x L log likelihood ratio LLR values based on a quantity n of columns of a target basis matrix and a lifting factor L that correspond to a target check matrix, wherein the target check matrix is a check matrix of a low-density parity-check LDPC code; and
a decoding module, configured to: decode the n x L LLR values based on a target element in the target basis matrix without using a non-target element in the target basis matrix to decode the n x L LLR values, wherein the target element is an L x L non-zero matrix, and the non-target element is an L x L zero matrix.

8. The apparatus according to claim 7, wherein the n x L LLR values are elements in n LLR sets, a quantity of elements in each of the n LLR sets is L, and the n LLR sets one-to-one correspond to the n columns in the target basis matrix; and
the decoding module is specifically configured to:
process a stored first LLR set based on a first element, wherein the first element is a target element in the i^{th} column in the target basis matrix; and
avoid processing a stored second LLR set based on a second element, wherein the second element is a non-target element in the i^{th} column in the target basis matrix; wherein
i is a positive integer greater than 0 and less than n + 1; and when the first element is located in the first row of the target basis matrix, the first LLR set is an LLR set corresponding to the i^{th} column in the n LLR sets, or when the first element is not located in the first row of the target basis matrix, the first LLR set is an LLR set updated based on a target element that is before the first element and that is closest to the first element; and
when the second element is located in the first row of the target basis matrix, the second LLR set is an LLR set corresponding to the i^{th} column in the n LLR sets, or when the second element is not located in the first row of the target basis matrix, the second LLR set is an LLR set updated based on a target element that is before the second element and that is closest to the second element.

9. The apparatus according to claim 8, wherein the decoding module is specifically configured to:
avoid reading the stored second LLR set.

10. The apparatus according to claim 8, wherein the apparatus is further configured to:
read the stored second LLR set; and
the decoding module is specifically configured to:
avoid performing an operation on the second element and L LLR values in the second LLR set.

11. The apparatus according to any one of claims 7 to 10, wherein the apparatus further comprises:
a second obtaining module, configured to obtain an initial basis matrix of the target check matrix, wherein the initial basis matrix is a matrix of m x n dimensions;
a determining module, configured to determine at least one target column based on elements comprised in the k^{th} row and the (k + 1)^{th} row of the initial basis matrix, wherein both an element in the k^{th} row and each of the at least one target column and an element in the (k + 1)^{th} row and each of the at least one target column are target elements, and k is a positive integer greater than 0 and less than m; and
a first adjusting module, configured to adjust, based on the at least one target column, a sequence of the elements comprised in the k^{th} row and the (k + 1)^{th} row, to obtain the target basis matrix, wherein the element in the k^{th} row and the at least one target column is located before another element in the k^{th} row after the sequence is adjusted, and the element in the (k + 1)^{th} row and the at least one target column is located after another element in the (k + 1)^{th} row after the sequence is adjusted.

12. The apparatus according to any one of claims 7 to 10, wherein the apparatus further comprises:
a second obtaining module, configured to obtain an initial basis matrix of the target check matrix, wherein the initial basis matrix is a matrix of m x n dimensions; and
a second adjusting module, configured to adjust a sequence of a plurality of rows of the initial basis matrix to obtain the target basis matrix, wherein a time overhead corresponding to the target basis matrix is less than a time overhead corresponding to the initial basis matrix, the time overhead corresponding to the target basis matrix is a time overhead generated when the n x L LLR values are decoded based on the target element in the target basis matrix, and the time overhead corresponding to the initial basis matrix is a time overhead generated when the n x L LLR values are decoded based on a target element in the initial basis matrix.

13. A decoding apparatus based on a low-density parity-check code, wherein the apparatus comprises:
a memory, comprising a program; and
a processor connected to the memory, wherein the processor is configured to execute the program, to set the decoding apparatus to perform the method according to any one of claims 1 to 6.

14. A computer-readable storage medium, wherein the computer-readable storage medium stores an instruction, and when the instruction is run on a computer, the computer is enabled to perform the method according to any one of claims 1 to 6.

15. A computer program product, wherein when the computer program product runs on a computer, the computer is enabled to perform the method according to any one of claims 1 to 6.
